# FASCICULE DE BREVET EUROPEEN

(11) **EP 1 559 303 B1**
(45) Date de publication et mention de la délivrance du brevet: **26.04.2006**
(21) Numéro de dépôt: 03810356.0
(22) Date de dépôt: 30.09.2003
(51) Int. Cl.: H05K 13/04

(54) **DISPOSITIF POUR L'EXTRACTION DE COMPOSANTS ELECTRONIQUES**
EINRICHTUNG ZUM EXTRAHIEREN ELEKTRONISCHER KOMPONENTEN
DEVICE FOR EXTRACTING ELECTRONIC COMPONENTS

(30) Priorité: 04.11.2002 CH 184002
(43) Date de publication de la demande: 03.08.2005
(73) Titulaire: ISMECA Semiconductor Holding SA, 2300 La Chaux-de-Fonds (CH)
(72) Inventeur: DROMARD, Pascal, F-25500 Montlebon (FR); FROIDEVAUX, Claude, CH-2300 La Chaux-de-Fonds (CH)
(74) Mandataire: P&TS Patents & Technology Surveys SA
(86) Numéro de dépôt international: PCT/CH2003/000654
(87) Numéro de publication internationale: WO 2004/043125

(56) Documents cités:
- EP-A- 0 565 781
- CH-A- 664 320
- US-A- 4 472 218
- US-A- 4 494 902

## Description

La présente invention concerne un dispositif pour l'extraction de composants électroniques, en particulier pour l'extraction de puces électroniques et/ou pour l'extraction d'autres composants électroniques, par exemple de composants encapsulés sans pattes (Lead Less Package, LLP), depuis une plaquette semiconductrice et/ou un "leadframe"découpés.

Les puces électroniques et les LLP, par exemple, sont des composants électroniques de très petite taille. Les puces électroniques sont formées par séries sur des plaquettes semiconductrices généralement circulaires d'environ 10 à 30 centimètres de diamètre. D'autres composants électroniques comme par exemple les LLP sont quant à eux généralement produits sur des plaquettes rectangulaires appelées "leadframe". Chaque plaquette peut comprendre jusqu'à quelques milliers de composants, par exemple de puces ou de LLP. Après leur fabrication, les composants électroniques sont séparés les uns des autres puis extraits un à un de leur plaquette.

Selon le principe adopté par la majorité des dispositifs d'extraction, les plaquettes sont collés sur une membrane élastique et découpées afin de singulariser les composants, par exemple les puces ou les LLP. Durant cette opération, la membrane doit rester intacte pour pouvoir être ensuite tendue sur un cadre rigide. Les composants électroniques sont ainsi écartés les uns des autres. L'extraction individuelle de chaque composant depuis la plaquette découpée se fait généralement par l'action conjuguée d'un ou de plusieurs extracteurs, par exemple une ou plusieurs aiguilles, poussant le composant électronique à extraire depuis dessous et d'une tête d'aspiration le prélevant depuis dessus.

Dans les dispositifs d'extraction de l'art antérieur, les mouvements du ou des extracteurs, sont généralement contrôlés par des vérins pneumatiques ou par des moteurs rotatifs liés à des systèmes de cames, tels que celui décrit par exemple dans le brevet US 5'755'373. Toutefois, l'accélération de ces systèmes est limitée par leur inertie due à la masse des pièces en mouvement. Leur vitesse est donc limitée, en particulier sur de courtes distances, limitant ainsi la cadence maximale des dispositifs d'extraction. Egalement en raison des masses en mouvement, de tels systèmes sont sujets au vieillissement rapide de leur mécanisme affectant ainsi leur longévité.

La demande de brevet EP0565781 décrit un dispositif d'extraction dans lequel l'extracteur, en l'occurrence une aiguille, est fixe tandis que le support sur lequel est posée la membrane est mobile. La conception d'un tel dispositif est cependant significativement plus complexe que celle des dispositifs dans lesquels le support est fixe et l'extracteur est mobile. De plus, les désavantages des dispositifs cités plus haut ne sont qu'accentués en raison de la masse importante du support, de la plaquette et de son cadre.

Une fois extraits, les composants électroniques sont généralement testés électriquement, contrôlés par vision et/ou conditionnés dans des bandes alvéolées, des mini plateaux, ou tout autre conditionnement utilisé pour de tels composants. Toutes ces opérations sont souvent effectuées sur les composants individuels par des lignes de traitement automatisées travaillant à des cadences élevées, nettement supérieures aux cadences des dispositifs d'extraction de l'art antérieur, requérant ainsi soit l'utilisation de plusieurs dispositifs d'extraction en parallèle pour chaque ligne de traitement (comme par exemple sur les lignes de "Die-bonding" de l'art antérieur), soit la diminution de la cadence de la ligne de traitement.

L'intégration des dispositifs d'extraction de l'art antérieur aux lignes de traitement est de plus généralement difficile en raison de leur encombrement. Les dispositifs d'extraction doivent pouvoir prélever tous les composants de la plaquette découpée, y compris ceux proches de la périphérie. Le point d'extraction étant généralement fixe, l'espace libre nécessaire autour de ce point d'extraction correspond pratiquement à un périmètre dont la plus grande dimension est égale au double de la plus grande dimension du cadre tenant la plaquette découpée. Dans ces conditions il est difficile, voire impossible, d'intégrer de tels dispositifs à des lignes de traitement articulées autour d'un convoyeur, car le point d'extraction ne peut être amené assez près du convoyeur pour que les puces ou les LLP soient directement prélevées lors de leur extraction par les porte-composants du convoyeur.

Le document US-A-4 472 218 est considéré comme étant l'état de la technique le plus proche de l'objet de l'invention. Ce document décrit un dispositif comprenant au moins un extracteur pour l'extraction de composants électroniques depuis une plaquette découpée en poussant un composant électronique à extraire hors de ladite plaquette découpée. Les composants sont extraits par l'action d'un extracteur actionné par un moteur pas-à-pas linéaire.

Un but de l'invention est ainsi de proposer un dispositif pour l'extraction de composants électroniques depuis une plaquette découpée pouvant travailler à des cadences plus élevées que celles des dispositifs d'extraction de l'art antérieur.

Un autre but de l'invention est de proposer un dispositif pour l'extraction de composants électroniques depuis une plaquette découpée pouvant être intégré directement à une ligne de traitement.

Un autre but de l'invention est de proposer un dispositif pour l'extraction de composants électroniques depuis une plaquette découpée ayant une grande longévité grâce à une faible usure de ses pièces mécaniques.

Ces buts sont atteints par un dispositif et une méthode possédant les caractéristiques des revendications indépendantes correspondantes, des variantes avantageuses étant en outre données par les revendications dépendantes.

En particulier, ces buts sont atteints par un dispositif pour l'extraction de composants électroniques depuis une plaquette découpée comprenant au moins une aiguille pour l'extraction des composants électroniques, la ou les aiguilles étant actionnées par un transducteur électromagnétique linéaire.

L'utilisation d'un transducteur électromagnétique linéaire, de préférence un moteur voice coil, pour la génération des mouvements du ou des extracteurs, par exemple de l'aiguille d'extraction, permet au dispositif d'extraction d'atteindre des cadences de travail très élevées, égales ou supérieures à celles de la plupart de lignes de traitement actuelles.

Bien que suggérée dans le domaine de l'extraction des composants électroniques, l'utilisation de transducteurs électromagnétiques est réservée au déplacement d'éléments mécaniques dont le mouvement ne requiert pas une grande précision et présentant, en raison leur masse élevée et/ou d'éléments élastiques supplémentaires, une inertie importante. Or les mouvements des transducteurs électromagnétiques n'impliquent que très peu de pièces en mouvement qui se déplacent pratiquement sans frottement. Leur inertie est donc faible, particulièrement dans le cas moteurs voice coil, dans lesquels la partie mobile est une bobine électrique, tandis que les éléments plus lourds, en particulier les aimants, sont fixes. Les transducteurs électromagnétiques en général et les moteurs voice coil en particulier sont ainsi capables de très fortes accélérations permettant des mouvements très rapides, particulièrement sur de courtes distances. Le dispositif de l'invention tire ainsi avantage de ces caractéristiques en utilisant un actuateur électromagnétique linéaire dont les mouvements rapides sont directement transmis à le ou les extracteurs dont la masse et la résistance au déplacement sont également faibles. La présente invention permet ainsi la réalisation de dispositifs d'extraction pouvant atteindre des cadences très élevées.

Selon la variante préférentielle de l'invention, le dispositif d'extraction possède en outre des moyens permettant la rotation dans le plan horizontal du cadre maintenant la plaquette découpée, réduisant ainsi sensiblement l'espace libre nécessaire autour du point d'extraction.

La présente invention sera mieux comprise à l'aide de la description de sa version préférentielle, illustrée par les figures 1 à 6, où
la figure 1 est une vue en perspective du dispositif d'extraction de composants, associé à une ligne de test et/ou de traitement, selon la version préférentielle de l'invention,
la figure 2 est une vue de profil du dispositif d'extraction de composants selon la version préférentielle de l'invention,
la figure 3 est une vue de face du dispositif d'extraction de composants selon la version préférentielle de l'invention,
la figure 4 est un détail de la tête du dispositif d'extraction et du mécanisme de maintien de la plaquette découpée,
les figures 5A à 5C illustrent les mouvements de l'aiguille du dispositif d'extraction et de la tête d'aspiration lors de l'extraction d'une puce depuis une plaquette découpée
et la figure 6 illustre schématiquement l'espace libre nécessaire autour du point d'extraction selon la version préférentielle du dispositif de l'invention.

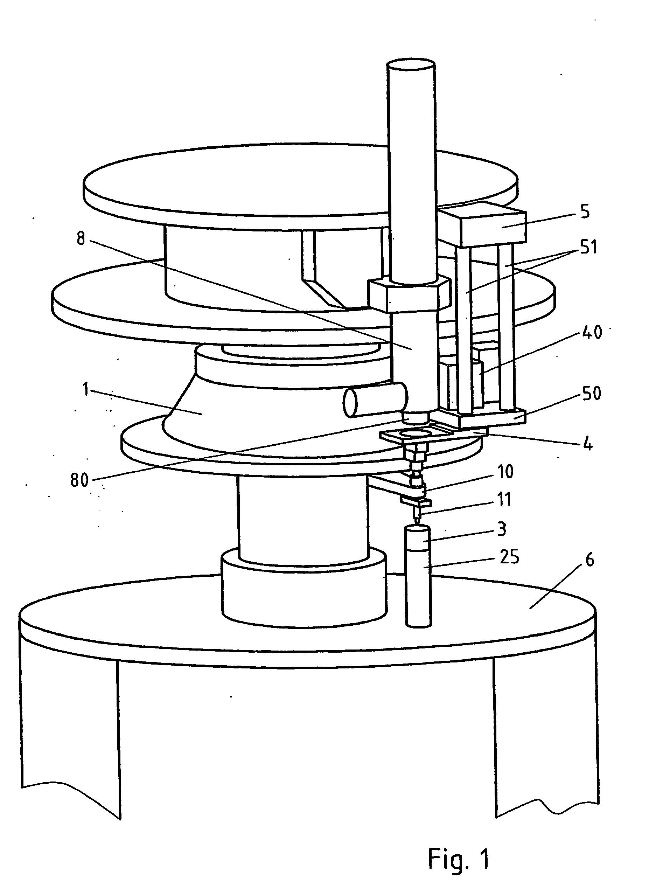

Dans sa version préférentielle illustrée par la figure 1, le dispositif d'extraction selon l'invention comprend un convoyeur 1, de préférence circulaire, autour duquel peuvent être répartis un certain nombre de postes de traitement non représentés, par exemple des postes de test ou de microsoudure. Les mouvements du convoyeur 1 sont de préférence indexés, définissant ainsi à sa périphérie un nombre déterminé d'emplacements auxquels les postes de traitement peuvent être disposés. Des porte-composants 11, de préférence des têtes d'aspiration, sont régulièrement répartis sur la périphérie du convoyeur 1, permettant ainsi le transport des composants électroniques d'un poste de traitement à l'autre. Pour des raisons de lisibilité, une seule tête d'aspiration 11 est représentée à la figure 1.

Un des emplacements définis autour du convoyeur est occupé par un nez de guidage 3 monté sur un support 25 de préférence cylindrique et vertical, au centre duquel se trouve une aiguille non représentée à la figure 1 servant à l'extraction des composants électroniques. A chaque pas du convoyeur 1, une tête d'aspiration 11 se retrouve précisément au-dessus du centre du nez de guidage 3 et par conséquent au-dessus de l'aiguille.

Une caméra 8 permettant de vérifier le centrage sur le nez de guidage 3 du composant électronique à extraire est placée au-dessus de ce dernier. Son objectif 80 est de préférence orienté vers le bas et centré par rapport au nez de guidage 3.

Un anneau de poussée 4 disposé entre l'objectif 80 de la caméra 8 et le nez de guidage 3 permet le contrôle du mouvement vertical de la tête d'aspiration 11 tout en laissant libre le centre du champ de vision de la caméra 8. L'anneau de poussée 4 permet de pousser la tête d'aspiration 11 vers le bas en appuyant sur les extrémités de sa partie supérieure. Les mouvements de l'anneau de poussée 4 sont générés par un moteur voice coil 40 disposé sur un plateau fixe 50 se trouvant au-dessus des têtes d'aspirations 11 et qui est lié par des éléments de fixation rigides 51, par exemple par des tiges rigides, à un élément fixe 5 de la structure du dispositif. Sur le plateau fixe 50 se trouve également une règle de mesure 49 permettant de mesurer les déplacements du moteur voice coil 40, et par conséquent ceux de l'anneau de poussée 4.

La plaquette découpée non représentée, depuis laquelle doivent être extraits les composants électroniques, est maintenue dans son cadre entre le nez de guidage 3 et la tête d'aspiration 11 par une table X-Y non représentée permettant également son déplacement horizontal.

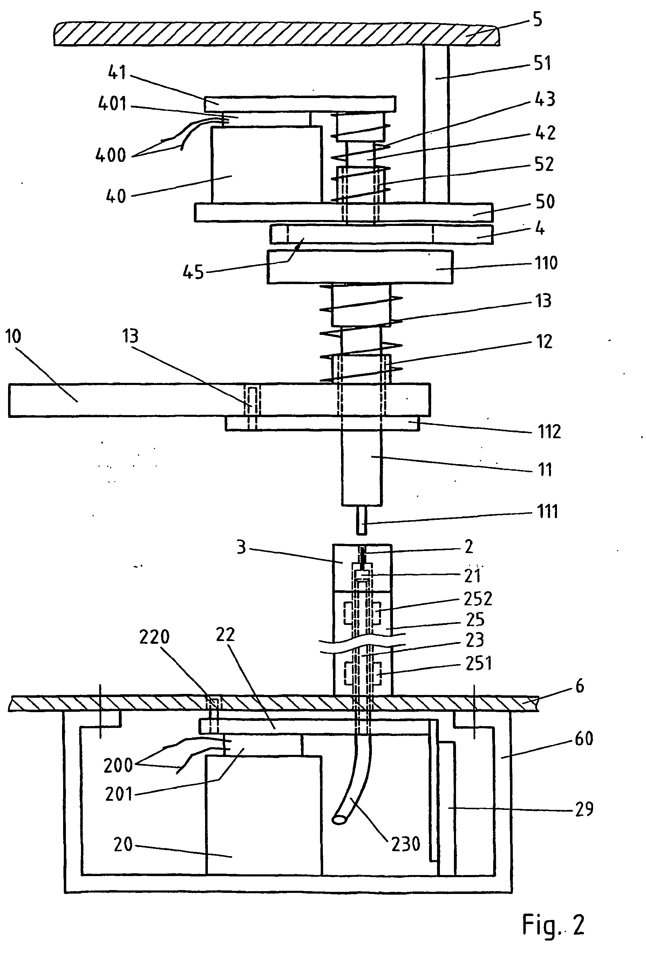

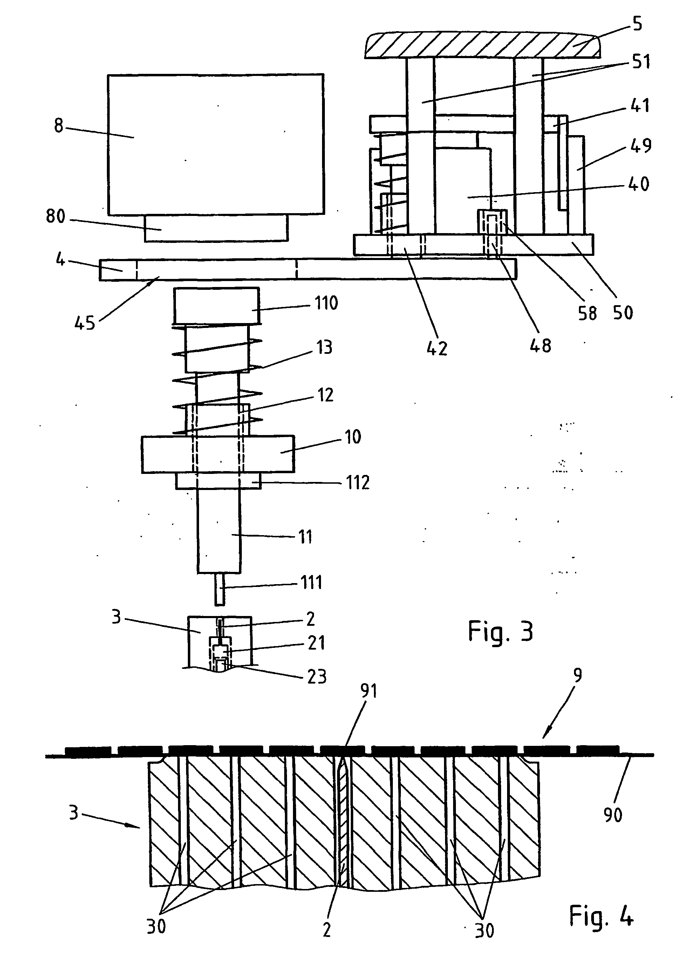

Les éléments principaux du dispositif d'extraction selon la version préférentielle de l'invention sont illustrés plus en détail par les figures 2 et 3. Sauf indication contraire, les numéros de référence identiques désignent le ou les mêmes éléments sur toutes les figures. La structure et le fonctionnement du dispositif d'extraction selon l'invention sont décrits ci-dessous dans le cadre de l'extraction de puces électroniques depuis une plaquette semiconductrice découpée. L'homme du métier comprendra cependant que la structure et le fonctionnement décrits sont également applicables à l'extraction de tout autre type de composants électroniques présentés en plaquette ou en "leadframe" durant une partie au moins de leur processus de fabrication, par exemple à l'extraction de LLP depuis un "leadframe" découpé.

Le support cylindrique 25 au sommet duquel se trouve le nez de guidage 3 est fixé sur la surface de référence 6 du dispositif d'extraction. Sur cette surface de référence 6 sont également fixés les autre postes de traitement non représentés disposés autour du convoyeur circulaire 1. Un tube d'extension 23 est maintenu à l'intérieur du support cylindrique 25 par deux douilles à billes 251, 252 lui permettant de coulisser verticalement. Un support 21 portant l'aiguille 2 pour l'extraction des puces est fixé au sommet du tube d'extension 23. L'extrémité de l'aiguille 2 peut sortir du centre du nez de guidage 3 par une ouverture qui sert également au passage de l'air pour l'aspiration et le soufflage du film souple.

Le tube d'extension 23 se prolonge vers le bas à travers la surface de référence 6 sous laquelle il est fixé à un plateau mobile22, lui-même lié à la bobine mobile 201 d'un moteur voice coil 20.

Les moteurs voice coil sont des transducteurs électromagnétiques dont la partie mobile est une bobine placée dans un champ magnétique généré par des aimants fixes. Lorsqu'un courant est injecté dans la bobine mobile, cette dernière subit une force dont la direction dépend du sens du courant, provoquant ainsi son déplacement. La bobine est de préférence guidée, par exemple par des rails ou dans des guidages à billes, et peut ainsi se déplacer le long d'un axe linéaire. Selon la version préférentielle de l'invention, cette fonction de guidage est remplie par les douilles à billes 251 et 252, avec l'aide de la goupille 220 pouvant coulisser dans un trou adapté sous la surface de référence 6 et empêchant ainsi la rotation du plateau mobile 22.

Le moteur voice coil 20 contrôlant les mouvements de l'aiguille 2 ainsi que les éléments qui lui sont liés sont avantageusement fixés sur un support fixe 60 se trouvant sous la surface de référence 6 à laquelle il est attaché, par exemple vissé, libérant ainsi la surface de référence 6 pour la table X-Y non représentée. Le moteur voice coil 20 est disposé de préférence de manière à ce que les déplacements de sa bobine mobile 201 se fassent selon un axe vertical. Les bornes électriques 200 de la bobine mobile 201 sont connectées à une source de courant contrôlée par le système de contrôle non représenté du dispositif. Le système de contrôle peut ainsi contrôler les mouvements vers le haut ou vers le bas de la bobine mobile 201, et par conséquent de l'aiguille 2, en faisant circuler dans la bobine mobile 201 un courant électrique de direction et d'intensité déterminées.

Les déplacements du plateau mobile 22, et par conséquent de l'aiguille 2, sont mesurés par une règle de mesure 29 dont les informations sont traitées par le système de contrôle.

L'extrémité inférieure du tube d'extension 23 est reliée par un tuyau 230 à un système pneumatique non représenté et également contrôlé par le système de contrôle du dispositif. Le système pneumatique peut aspirer et/ou souffler de l'air à travers le tube d'extension 23 qui est ouvert à son extrémité supérieure, sous le support 21 de l'aiguille 2. Un vide d'air et/ou une surpression dont l'utilisation est expliquée plus loin peuvent ainsi être générés dans le nez de guidage 3.

Les têtes d'aspiration 11, dont une seule est représentée sur les figures 2 et 3, sont maintenues par des douilles à bille 12 fixées à l'extrémité des bras 10 du convoyeur circulaire 1 et dans lesquelles elles peuvent coulisser verticalement. Un ressort 13 placé entre le bras 10 du convoyeur 1 et la partie supérieure 110 de la tête d'aspiration 11 maintient cette dernière dans sa position haute. Une pièce de butée112 enserrant la partie inférieure de la tête d'aspiration 11 détermine cette position haute en limitant le déplacement vers le haut de la tête d'aspiration 11. La pièce de butée 112 comporte de préférence une goupille 113 pouvant coulisser dans un orifice correspondant pratiqué dans le bras 10 du convoyeur 1, évitant ainsi toute rotation de la tête d'aspiration 11.

L'anneau de poussée 4 permet de descendre la tête d'aspiration 11 se trouvant au-dessus du nez de guidage 3. II est relié par une goupille 42 à un plateau mobile 41 solidaire de la bobine mobile 401 du moteur voice coil 40. La goupille 42 est maintenue dans une douille à billes 52 fixée sur le plateau fixe 50 et dans laquelle elle peut coulisser verticalement. Un ressort 43 placé entre le plateau fixe 50 et le plateau mobile 41, de préférence autour de la goupille 42, maintient l'anneau de poussée 4 vers le haut, en butée contre le plateau fixe 50. Dans cette position, l'anneau de poussée 4 n'est pas en contact avec la tête d'aspiration 11 se trouvant sous lui et le convoyeur 1 peut être avancé d'un pas afin de présenter une nouvelle tête d'aspiration 11 sous l'anneau de poussée 4.

Les bornes 400 de la bobine mobile 401 du moteur voice coil 40 sont connectées à une source de courant non représentée contrôlée de préférence par le système de contrôle du dispositif. Les mouvements de la bobine mobile 401, et par conséquent de l'anneau de poussée 4, sont ainsi contrôlés par le système de contrôle qui peut en particulier abaisser le plateau mobile 41 contre la force du ressort 43 en faisant circuler un courant de direction appropriée à travers la bobine mobile 401. L'anneau de poussée 4, en s'abaissant, entraîne dans son mouvement la tête d'aspiration 11 se trouvant sous lui en appuyant sur les extrémités de sa partie supérieure 110. Afin d'éviter toute rotation indésirable, l'anneau de poussée 4 comprend une goupille 48 coulissant dans une douille 58 fixée au plateau fixe 50 (figure 3).

Les mouvements du plateau mobile 41 sont de préférence mesurés par une règle de mesure 49 dont les données sont traitées par le système de contrôle, permettant ainsi à ce dernier un meilleur contrôle des mouvements de l'anneau de poussée 4 et donc de la tête d'aspiration 11 se trouvant sous l'anneau de poussée 4, au-dessus du nez de guidage 3.

La position de la caméra 8 est illustrée à la figure 3. L'objectif 80 est orienté vers le bas, au-dessus du nez de guidage 3, face à l'ouverture 45 de l'anneau de poussée 4. Lors des mouvements du convoyeur 1, la tête d'aspiration 11 ayant prélevé une puce électronique est écartée du nez de guidage 3, libérant ainsi le champ de la caméra 8 qui peut alors filmer, à travers l'ouverture 45 de l'anneau de poussée 4, la position de la prochaine puce à extraire se trouvant sur le nez de guidage 3. Le champ de la caméra 8 est ensuite à nouveau occupé par la nouvelle tête d'aspiration 11 présentée au-dessus du nez de guidage 3 par le convoyeur 1.

La figure 4 montre en coupe un détail du nez de guidage 3 sur lequel se trouve la plaquette découpée 9. La plaquette découpée 9 est collée sur la membrane élastique 90 qui est tendue sur un cadre non représenté. La plaquette découpée 9 est positionnée de manière à ce que la prochaine puce électronique à extraire 91 soit placée au centre du nez de guidage 3. Le nez de guidage 3 comprend des buses 30 liées au tube d'extension 23 et réparties autour de l'aiguille 2 par lesquelles de l'air peut être aspiré afin de plaquer fermement la membrane élastique 90 contre la surface supérieure du nez de guidage 3. De préférence, de l'air peut également être soufflé par ces buses 30 afin de faciliter le déplacement de la plaquette 9 lors du centrage de la puce électronique à extraire 91.

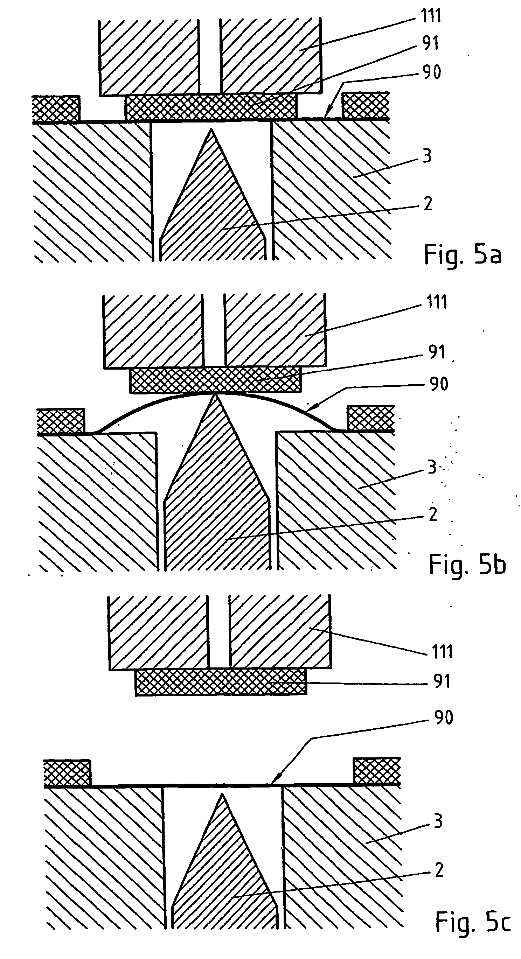

Une fois centrée, la puce électronique à extraire 91 se trouve précisément au-dessus de l'aiguille 2. Les étapes principales de l'extraction de la puce 91 sont illustrées par les figure 5A à 5B. Dans un premier temps, la tête d'aspiration 11 est abaissée jusqu'à entrer en contact avec la puce 91. De l'air est aspiré par la buse de la tête d'aspiration 11 afin de maintenir la puce 91 par vide d'air. L'aiguille 2 et la tête d'aspiration 11 sont ensuite élevées simultanément, soulevant ainsi la puce électronique 91 et la détachant partiellement de la membrane élastique 90. La parfaite synchronisation des mouvements de l'aiguille 2 et de la tête d'aspiration 11 est très importante pour la qualité et la reproductibilité de l'extraction. Elle est réalisée de manière optimale grâce à la symétrie des motorisations: le même moteur voice coil et la même règle de mesure sont utilisés pour les deux éléments, et les masses embarquées sont semblables.

Lors de l'extraction, les puces électroniques voisines de la puce à extraire 91 restent plaquées contre la surface du nez de guidage 3, sous l'action de l'air aspiré par les buses 30. La tête d'aspiration 11 est ensuite relevée au maximum tandis que l'aiguille 2 est abaissée à nouveau. La puce 91 est alors détachée de la membrane élastique 90 qui revient dans sa position initiale. Le convoyeur 1 peut alors être avancé d'un pas afin de transporter la puce 91 vers le prochain poste de traitement, par exemple vers un poste de test.

Après chaque extraction de puce électronique, pendant l'avance d'un pas du convoyeur, la plaquette découpée 9 est déplacé par la table X-Y afin de présenter une nouvelle puce à extraire au centre du nez de guidage 3. Durant les déplacements de la plaquette découpée 9, de l'air est de préférence soufflé par les buses 30, facilitant ainsi le glissement de la membrane 90 sur la surface du nez de guidage 3. Dans un premier mouvement, la plaquette 9 est déplacée sans contrôle visuel de manière à approcher la prochaine puce à extraire du centre du nez de guidage 3. La position réelle de la prochaine puce à extraire est filmée par la caméra 8 lorsque son objectif 80 est libre de toute tête d'aspiration 11. Les données sont transmises au système de contrôle qui calcule les corrections nécessaires afin que la puce soit parfaitement centrée. La position de la plaquette 9 est alors corrigée selon les instructions du système de contrôle durant les derniers instants du mouvement du convoyeur 1. L'air est ensuite aspiré par les buses 30 du nez de guidage 3 afin de plaquer la membrane élastique 90 contre la surface du nez de guidage 3. La prochaine puce peut alors être extraite de la plaquette découpée 9.

La masse en mouvement des moteurs voice coil 20, 40 utilisés pour la motorisation de l'aiguille 2 et de l'anneau de poussée 4 du dispositif selon la version préférentielle de l'invention étant très faible, généralement à peine plus élevée que la masse de leur bobine mobile 201, 401, ces moteurs peuvent être soumis à de très fortes accélérations, permettant ainsi des mouvements répétés à des cadences très élevées, particulièrement sur de courtes distances. L'utilisation de tels actuateurs pour la motorisation d'une aiguille 2 pour l'extraction des puces électroniques permet de concevoir des dispositifs d'extraction dont la cadence est suffisante pour être directement intégrés sur des lignes automatiques de traitement sans ralentir ces dernières. Les puces peuvent ainsi être extraites directement de la plaquette découpée 9 par les porte-composants 11 du convoyeur qui les transporteront également sur les postes de traitement suivants, évitant ainsi tout équipement de transport intermédiaire.

Les puces sont cependant généralement produites en grande série sur des plaquettes de relativement grandes dimensions. Afin que toutes les puces puissent être extraites de la plaquette découpée 9, cette dernière doit pouvoir être déplacée librement autour du point d'extraction, dans un rayon au moins égal au diamètre de la plaquette. Cette contrainte rend difficile, voire impossible, la disposition de l'aiguille d'extraction 2 sous les porte-composants 11 d'un convoyeur, particulièrement d'un convoyeur circulaire 1 dont les bras 10 sont rarement très éloignés de son centre.

La table X-Y non représentée du dispositif selon la version préférentielle de l'invention, qui maintient la plaquette découpée 9 entre le nez de guidage 3 et la tête d'aspiration 11, comporte ainsi de préférence un actionneur permettant de tourner la plaquette découpée dans le plan horizontal. Ainsi, par exemple, les puces électroniques se trouvant dans la moitié de la plaquette la plus proche du centre du convoyeur peuvent être extraites en premier, la plaquette étant ensuite tournée de 180° pour permettre l'extraction des puces de l'autre moitié de la plaquette sans que le cadre ne doive être approché plus du centre du convoyeur 1.

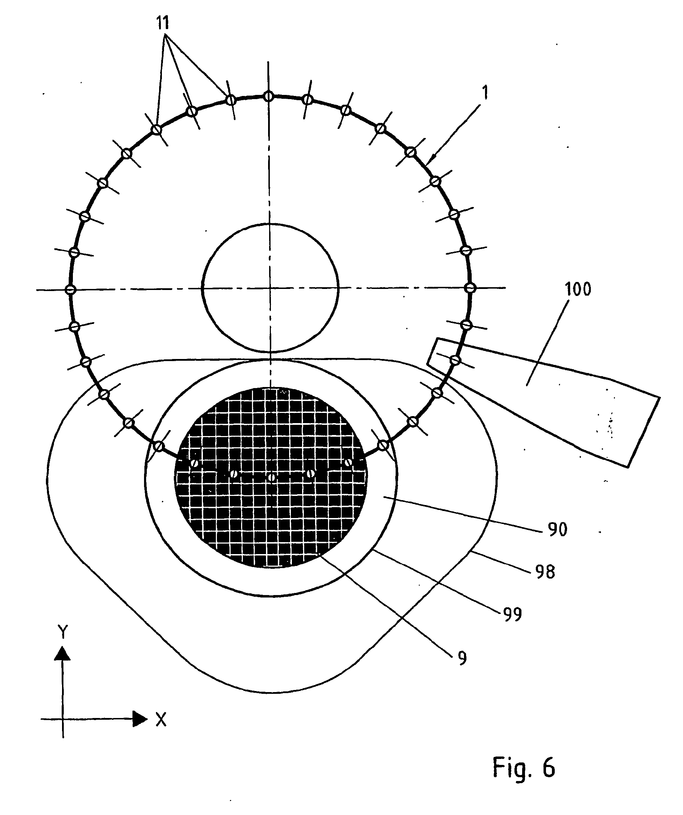

L'encombrement réduit autour du point d'extraction obtenu grâce à la rotation de la plaquette découpée 9 est illustré à la figure 6 qui est une vue schématique de dessus du dispositif selon la version préférentielle de l'invention. Le convoyeur 1 du dispositif est un convoyeur circulaire possédant trente-deux positions discrètes, et par conséquent trente-deux emplacements potentiels et trente-deux porte-composants 11 à sa périphérie.

La plaquette découpée 9, collée sur la membrane élastique 90, est maintenue sur le cadre 99. Le cadre 99 est placé horizontalement entre le nez de guidage non représenté et une des têtes d'aspiration 11 du convoyeur 1. Selon la disposition illustrée schématiquement à la figure 6, la plaquette découpée 9 est centrée sur le nez de guidage. Le dispositif selon l'invention comprend un actionneur non représenté pouvant tourner le cadre 99, et par conséquent la plaquette découpée 9, de 180° dans le plan horizontal. Dans un premier temps, seules les puces électroniques se trouvant dans la moitié de la plaquette découpée 9 la plus proche du centre du convoyeur sont extraites. Le cadre 99 est ensuite tourné de 180°, la moitié de la plaquette découpée 9 comportant encore des puces à extraire se trouvant alors à son tour près du centre du convoyeur 1. Ainsi, seules les puces à extraire se trouvant dans la moitié de la plaquette 9 la plus proche du centre du convoyeur 1 doivent pouvoir être amenées au-dessus du centre du nez de guidage.

Le périmètre dans lequel, selon ce procédé, le cadre 99 doit pouvoir être déplacé par la table X-Y non représentée est indiqué par le pourtour 98. De la figure 6, il est clairement visible que grâce à cette rotation le nez de guidage peut être placé sensiblement plus proche du centre du convoyeur, permettant l'extraction de toutes les puces de la plaquette 9 directement par les porte-composants 11 du convoyeur 1, sans que ces derniers ne doivent être placés trop loin du centre du convoyeur 1.

L'homme du métier comprendra que ce procédé de rotation de la plaquette découpée 9 peut également être adapté à tout autre système d'extraction de l'art antérieur afin de réduire l'espace libre nécessaire autour du point d'extraction des puces électroniques.

La figure 6 montre en outre que l'espace nécessaire au déplacement de la plaquette découpée 9 autour du nez de guidage empêche généralement l'utilisation de tous les emplacements définis autour du convoyeur. Afin de ne pas se retrouver à l'intérieur du périmètre 98, le prochain poste de traitement 100 doit en effet être disposé à quelques emplacements de celui occupé par le nez de guidage.

Le dispositif d'extraction selon la version préférentielle de l'invention ne comporte qu'une seule aiguille d'extraction. II est ainsi particulièrement adapté pour l'extraction de composants électroniques de très petite taille. L'homme du métier comprendra cependant aisément que le dispositif selon l'invention peut être adapté pour comporter plusieurs aiguilles permettant ainsi l'extraction de composants de plus grande taille.

L'homme du métier comprendra également que la ou les aiguilles d'extraction peuvent être remplacées, dans le cadre de l'invention, par tout autre type d'extracteur mobile poussant le composant électronique à extraire hors de la plaquette découpée. Le ou les extracteurs peuvent par exemple comporter une partie supérieure adaptée spécifiquement à un type de composants particulier dont elle épouse la forme afin d'éviter tout dommage au cours de l'extraction.

Le dispositif d'extraction selon la version préférentielle de l'invention comprend un convoyeur circulaire. II est toutefois envisageable d'envisager d'autres formes de convoyeurs tels que des convoyeurs linéaires, par exemple.

## Revendications

1. Dispositif comprenant au moins un extracteur (2) pour l'extraction de composants électroniques depuis une plaquette découpée (9) en poussant un composant électronique à extraire (91) hors de ladite plaquette découpée (9), **caractérisé en ce que** ledit au moins un extracteur (2) est actionnée par un transducteur électromagnétique linéaire (20).

2. Dispositif selon la revendication précédente, ledit au moins un extracteur étant une aiguille d'extraction (2).

3. Dispositif selon l'une des revendications précédentes, ledit transducteur électromagnétique linéaire étant un moteur voice coil (20).

4. Dispositif selon l'une des revendications précédentes, comprenant un convoyeur (1) pour le transport desdits composants électroniques vers une pluralité de postes de traitement successifs (100).

5. Dispositif selon la revendication précédente, ledit convoyeur (1) comprenant au moins une tête d'aspiration (11) pour le prélèvement et le maintien desdits composants électroniques.

6. Dispositif selon l'une des revendications 4 ou 5, ledit convoyeur (1) étant un convoyeur circulaire à mouvement indexé, lesdits postes de traitement successifs (100) étant disposés à la périphérie dudit convoyeur circulaire (1).

7. Dispositif selon l'une des revendications 4 à 6, comprenant un élément de poussée (4) pour le contrôle des mouvements verticaux de ladite au moins une tête d'aspiration (11) lors du prélèvement desdits composants électroniques.

8. Dispositif selon la revendication précédente, ledit élément de poussée (4) étant actionné par un deuxième transducteur électromagnétique linéaire (40).

9. Dispositif selon la revendication précédente, ledit deuxième transducteur électromagnétique linéaire étant un moteur voice coil (40).

10. Dispositif selon l'une des revendications 7 à 9 comprenant une caméra (8) pour le contrôle de la position dudit composant électronique à extraire (91), ladite caméra (8) étant disposée sensiblement verticalement au-dessus dudit élément de poussée (4).

11. Dispositif selon la revendication précédente, ledit contrôle étant effectué durant le mouvement dudit convoyeur (1).

12. Dispositif selon l'une des revendications précédentes comprenant un actionneur pour la rotation horizontale de ladite plaquette découpée (9).

13. Procédé pour l'extraction de composants électroniques depuis une plaquette découpée (9), ladite extraction étant effectuée à l'aide d'au moins un extracteur (2) poussant un composant électronique à extraire (91) hors de ladite plaquette découpée (9), **caractérisé en ce que** ledit au moins un extracteur (2) est actionné par un transducteur électromagnétique.

14. Procédé selon la revendication précédente, ledit extracteur étant une aiguille d'extraction (2).

15. Procédé selon l'une des revendications précédentes, ladite extraction comprenant les étapes suivantes:
abaissement d'une tête d'aspiration (11) se trouvant au-dessus dudit composant électronique à extraire (91) de ladite plaquette découpée (9) jusqu'à ce que ladite tête d'aspiration (11) entre en contact avec ledit composant électronique (91) à extraire,
maintien par aspiration d'air dudit composant électronique à extraire (91) contre ladite tête d'aspiration (11),
élévation simultanée de ladite au moins une aiguille (2) et de ladite tête d'aspiration (11),
abaissement de ladite au moins une aiguille (2) dans sa position initiale et élévation simultanée de la tête d'aspiration (11).

16. Procédé selon la revendication précédente, comprenant en outre une étape de rotation de ladite plaquette découpée (9).

17. Procédé selon l'une des revendications 15 ou 16, ladite tête d'aspiration (11) étant associée à un convoyeur (1).

## Patentansprüche

1. Vorrichtung mit mindestens einem Extraktor (2) für das Extrahieren elektronischer Komponenten aus einer ausgeschnittenen Platte (9), indem eine zu extrahierende elektronische Komponente (91) aus der besagten ausgeschnittenen Platte (9) gestossen wird, **dadurch gekennzeichnet, dass** mindestens ein Extraktor (2) durch einen elektromagnetischen Linearwandler (20) getätigt wird.

2. Vorrichtung gemäss dem vorhergehenden Anspruch, wobei der besagte mindestens eine Extraktor eine Extraktionsnadel (2) ist.

3. Vorrichtung gemäss einem der vorhergehenden Ansprüche, wobei der besagte elektromagnetische Linearwandler ein Schwingspulemotor (20) ist.

4. Vorrichtung gemäss einem der vorhergehenden Ansprüche, mit einem Förderer (1) für den Transport der besagten elektronischen Komponenten nach einer Vielzahl von aufeinander folgenden Verarbeitungsstationen (100).

5. Vorrichtung gemäss dem vorhergehenden Anspruch, wobei der besagte Förderer (1) mindestens einen Saugkopf (11) für das Entnehmen und das Halten der besagten elektronischen Komponente enthält.

6. Vorrichtung gemäss einem der Ansprüche 4 oder 5, wobei der besagte Förderer (1) ein Kreisförderer mit indexierter Bewegung ist, wobei die besagten aufeinander folgenden Verarbeitungsstationen (100) auf der Peripherie des besagten Kreisförderers (1) angeordnet sind.

7. Vorrichtung gemäss einem der Ansprüche 4 bis 6, mit einem Stosselement (4) für die Kontrolle der senkrechten Bewegungen des besagten mindestens einen Saugkopfes (11) während der Entnahme der besagten elektronischen Komponenten.

8. Vorrichtung gemäss dem vorhergehenden Anspruch, wobei das besagte Stosselement (4) durch einen zweiten elektromagnetischen Linearwandler (40) getätigt wird.

9. Vorrichtung gemäss dem vorhergehenden Anspruch, wobei der besagte zweite elektromagnetische Linearwandler ein Schwingspulemotor (40) ist.

10. Vorrichtung gemäss einem der Ansprüche 7 bis 9, mit einer Kamera (8) für die Kontrolle der Position der besagten zu extrahierenden elektronischen Komponente (91), wobei die besagte Kamera (8) mehr oder weniger senkrecht über das besagte Stosselement (4) angeordnet wird.

11. Vorrichtung gemäss dem vorhergehenden Anspruch, wobei die besagte Kontrolle während der Bewegung des besagten Förderers (1) durchgeführt wird.

12. Vorrichtung gemäss einem der vorhergehenden Ansprüche, mit einem Aktor für die waagrechte Drehung der besagten ausgeschnittenen Platte (9).

13. Verfahren für das Extrahieren elektronischer Komponenten aus einer ausgeschnittenen Platte (9), wobei die besagte Extraktion mittels mindestens einem Extraktor (2) durchgeführt wird, der eine zu extrahierende elektronische Komponente (91) aus der besagten ausgeschnittenen Platte (9) stösst, **dadurch gekennzeichnet, dass** der besagte mindestens eine Extraktor (2) durch einen elektromagnetischen Linearwandler (20) getätigt wird.

14. Verfahren gemäss dem vorhergehenden Anspruch, wobei der besagte Extraktor eine Extraktionsnadel (2) ist.

15. Verfahren gemäss einem der vorhergehenden Ansprüche, wobei die besagte Extraktion die folgenden Schritte umfasst:
Senken eines Saugkopfes (11), der sich über der besagten aus der besagten ausgeschnittenen Platte (9) zu extrahierenden elektronischen Komponente (91) befindet, bis der besagte Saugkopf (11) in Kontakt mit der besagten zu extrahierenden elektronischen Komponente (91) kommt,
Halten durch Luftsaugen der besagten zu extrahierenden elektronischen Komponente (91) gegen den besagten Saug kopf (11),
gleichzeitiges Heben der besagten mindestens einen Nadel (2) und des besagten Saugkopfes (11),
Senken der besagten mindestens einen Nadel (2) in ihre Anfangsposition und gleichzeitiges Heben des Saugkopfes (11).

16. Verfahren gemäss dem vorhergehenden Anspruch, ferner mit einem Schritt der Drehung der besagten ausgeschnittenen Platte (9).

17. Verfahren gemäss einem der Ansprüche 15 oder 16, wobei der besagte Saugkopf (11) mit einem Förderer (1) verbunden ist.

## Claims

1. Device comprising at least one extractor (2) for extracting electronic components from a cutout wafer (9), by pushing one electronic component to be extracted (91) out of said cutout wafer (9), **characterized in that** said at least one extractor (2) is actuated by a linear electromagnetic transducer (20).

2. Device according to the preceding claim, said at least one extractor being an extraction needle (2).

3. Device according to one of the preceding claims, said linear electromagnetic transducer being a voice coil motor (20).

4. Device according to one of the preceding claims, comprising a conveyor (1) for transporting said electronic components (91) to a plurality of successive processing stations (100).

5. Device according to the preceding claim, said conveyor (1) comprising at least one aspiration head (11) for removing and holding said electronic components (91).

6. Device according to one of the claims 4 or 5, said conveyor (1) being a circular conveyor with indexed movement, said successive processing stations (100) being placed at the periphery of said circular conveyor (1).

7. Device according to one of the claims 4 to 6, comprising a pushing element (4) for controlling the vertical movements of said at least one aspiration head (11) during removal of said electronic components (91).

8. Device according to the preceding claim, said pushing element (4) being actuated by a second linear electromagnetic transducer (40).

9. Device according to the preceding claim, said second linear electromagnetic transducer being a voice coil motor (40).

10. Device according to one of the claims 7 to 9, comprising a camera (8) for controlling the position of said electronic component to be extracted (91), said camera (8) being placed more or less vertically above said pushing element (4).

11. Device according to the preceding claim, said control being performed during the movement of said conveyor (1).

12. Device according to one of the preceding claims, comprising an actuator for horizontally rotating said cutout wafer (9).

13. Method for extracting electronic components (91) from a cutout wafer (9), said extraction being effected by means of at least one extractor (2) pushing an electronic component to be extracted (91) outside of said cutout wafer (9), **characterized in that** said at least one extractor (2) is actuated by an electromagnetic transducer.

14. Method according to the preceding claim, said extractor being an extraction needle (2).

15. Method according to one of the claims 13 or 14, said extraction comprising the following steps:
lowering an aspiration head (11) situated above an electronic component (91) to be extracted from said cutout wafer (9) until said aspiration head (11) comes into contact with said electronic component to be extracted (91),
holding by air aspiration said electronic component to be extracted (91) against said aspiration head (11),
simultaneously raising said at least one needle (2) and said aspiration head (11),
lowering said at least one needle (2) to its initial position and simultaneously raising the aspiration head (11).

16. Method according to the preceding claim, further comprising a step of rotating said cutout wafer (9).

17. Method according to one of the claims 15 or 16, said aspiration head (11) being associated to a conveyor (1).
